# EUROPEAN PATENT APPLICATION

(11) **EP 4 404 270 A1**
(43) Date of publication of application: **24.07.2024**
(21) Application number: 23205075.7
(22) Date of filing: 23.10.2023
(51) Int. Cl.: H01L 29/06, H01L 21/283, H01L 29/16, H01L 29/66, H01L 29/78

(54) **FIELD-EFFECT TRANSISTORS FORMED USING A WIDE BANDGAP SEMICONDUCTOR MATERIAL**

(30) Priority: 19.01.2023 US 202318098999
(71) Applicant: GlobalFoundries U.S. Inc., Malta, NY 12020 (US)
(72) Inventor: HEBERT, Francois, Santa Clara, CA, 95054 (US)
(74) Representative: Lambacher, Michael

(57) **Abstract**

Structures for a field-effect transistor and methods of forming such structures. The structure comprises a semiconductor substrate including a top surface, a doped region adjacent to the top surface, and a trench that extends through the doped region. The semiconductor substrate comprises a wide bandgap semiconductor material. The structure further comprises a gate structure including a gate conductor layer. The gate conductor layer has a first portion disposed above the top surface of the semiconductor substrate and a second portion disposed inside the trench below the top surface of the semiconductor substrate.

## Description

### BACKGROUND

The disclosure relates to semiconductor devices and integrated circuit manufacture and, more specifically, to structures for a field-effect transistor and methods of forming such structures.

Wide bandgap semiconductors, such as silicon carbide, may be used in high-power applications and/or high-temperature applications. Silicon carbide is well suited for power switching because of its advantageous properties, such as a high saturated drift velocity, a high critical field strength, an exceptional thermal conductivity, and a significant mechanical strength. A metal-oxide-semiconductor field-effect transistor is a type of gate-voltage-controlled power switching device that uses field inversion as a current control mechanism. A metal-oxide-semiconductor field-effect transistor may leverage the favorable properties of a silicon carbide substrate to enable, for example, power converters, motor inverters, and motor drivers that are characterized by high reliability and high efficiency when operating at a high voltage.

Improved structures for a field-effect transistor and methods of forming such structures are needed.

### SUMMARY

In an embodiment of the invention, a structure for a field-effect transistor is provided. The structure comprises a semiconductor substrate including a top surface, a doped region adjacent to the top surface, and a trench that extends through the doped region. The semiconductor substrate comprises a wide bandgap semiconductor material. The structure further comprises a gate structure including a gate conductor layer. The gate conductor layer has a first portion disposed above the top surface of the semiconductor substrate and a second portion disposed inside the trench below the top surface of the semiconductor substrate.
The gate structure may further include a silicide layer on the first portion of the gate conductor layer. The silicide layer and the trench may have substantially equal width dimensions. Moreover, the gate conductor layer may extend through the doped region.
The structure may further comprise a dielectric layer on the first portion of the gate conductor layer. The dielectric layer and the trench may have substantially equal width dimensions. Moreover, the structure may additionally comprise a dielectric spacer on the dielectric layer.
Moreover, the wide bandgap semiconductor material may comprise silicon carbide.

In an embodiment of the invention, a method of forming a structure for a field-effect transistor is provided. The method comprises forming a doped region in a semiconductor substrate adjacent to a top surface of the semiconductor substrate, forming a trench in the semiconductor substrate, and forming a gate structure including a gate conductor layer. The semiconductor substrate comprises a wide bandgap semiconductor material, the trench extends through the doped region, and the gate conductor layer has a first portion disposed above the top surface of the semiconductor substrate and a second portion disposed inside the trench below the top surface of the semiconductor substrate.
The step of forming the trench in the semiconductor substrate may comprise forming a hardmask on the top surface of the semiconductor substrate, wherein the trench extends through the hardmask into the semiconductor substrate.
According to one variant the method may further comprise forming a silicide layer on the first portion of the gate conductor layer, and removing the hardmask after forming the silicide layer.
According to another variant, the method may further comprise recessing the gate conductor layer relative to a top surface of the hardmask. The recessed gate conductor layer may have a top surface disposed between the top surface of the hardmask and the top surface of the semiconductor substrate. Further, the method may additionally comprise forming a silicide layer on the gate conductor layer, forming a dielectric layer inside a portion of the trench over the silicide layer and the gate conductor layer, and removing the hardmask after forming the silicide layer and the dielectric layer.
According to still another variant, the method may further comprise recessing the gate conductor layer relative to a top surface of the hardmask, and forming a dielectric layer inside a portion of the trench over the gate conductor layer.
According to still another variant, the method may further comprise removing the hardmask after forming the gate structure; and forming a dielectric layer by an oxidation process on the gate conductor layer after removing the hardmask.
In all the above variants, the hardmask may comprise a material having a melting point that is greater than or equal to 2000 °C. For instance, the hardmask may comprise aluminum nitride, or polycrystalline silicon carbide.
In a further development, the hardmask may include a first layer and a second layer that is disposed on the first layer. The first layer may comprise aluminum oxide, and the second layer may comprise aluminum nitride or polycrystalline silicon carbide. Alternatively, the first layer may comprise aluminum nitride, and the second layer may comprise polycrystalline silicon carbide.

### BRIEF DESCRIPTION OF THE DRAWINGS

The accompanying drawings, which are incorporated in and constitute a part of this specification, illustrate various embodiments of the invention and, together with a general description of the invention given above and the detailed description of the embodiments given below, serve to explain the embodiments of the invention. In the drawings, like reference numerals refer to like features in the various views.
FIGS. 1-6 are cross-sectional views of a structure at successive fabrication stages of a processing method in accordance with embodiments of the invention.
FIGS. 7-8 are cross-sectional views of a structure at successive fabrication stages of a processing method in accordance with alternative embodiments of the invention.
FIGS. 9-11 are cross-sectional views of a structure at successive fabrication stages of a processing method in accordance with alternative embodiments of the invention.

### DETAILED DESCRIPTION

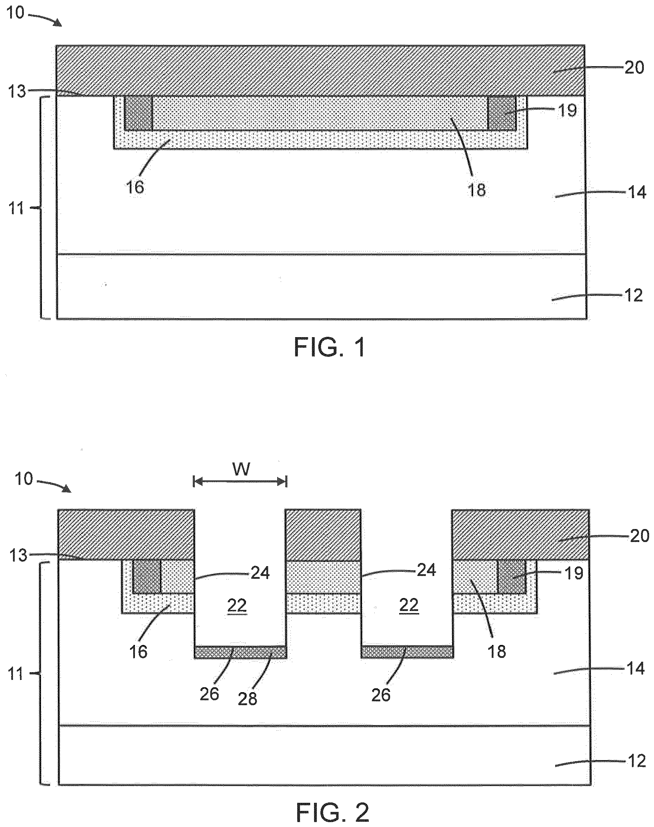

With reference to FIG. 1 and in accordance with embodiments of the invention, a structure 10 for a field-effect transistor may be formed using a semiconductor substrate 11 that includes a bulk substrate 12 and a semiconductor layer 14 formed by, for example, epitaxial growth on the bulk substrate 12. In an embodiment, the semiconductor layer 14 of the semiconductor substrate 11 may be comprised of a wide bandgap semiconductor material, such as silicon carbide. In an embodiment, the bulk substrate 12 of the semiconductor substrate 11 may be comprised of a wide bandgap semiconductor material. In an embodiment, the semiconductor substrate 11 may be comprised of silicon carbide, which is a wide bandgap semiconductor material. In an embodiment, the semiconductor substrate 11 may be comprised of diamond, which is a wide bandgap semiconductor material. In an embodiment, the bulk substrate 12 and the semiconductor layer 14 may be comprised of a semiconductor material having a melting point greater than the melting point of silicon. In an embodiment, the bulk substrate 12 and the semiconductor layer 14 may be comprised of silicon carbide that is doped to have n-type electrical conductivity. In an embodiment, the bulk substrate 12 and the semiconductor layer 14 may be comprised of silicon carbide that is doped to have n-type electrical conductivity with the bulk substrate 12 having a higher dopant concentration and a lower electrical resistivity than the semiconductor layer 14. In an embodiment, the bulk substrate 12 may have a resistivity of less than 25 mOhm-cm. In an embodiment, the semiconductor layer 14 may include a buffer sublayer grown directly on the bulk substrate 12 and a drift sublayer grown on the buffer sublayer, and the drift sublayer may have a dopant concentration and a thickness that are optimized for device operation in a 650 volt to 1200 volt range. In an embodiment, the bulk substrate 12 may operate as the drain of the field-effect transistor.

A doped region 16 may be formed in the semiconductor layer 14 adjacent to a top surface 13 of the semiconductor substrate 11. The doped region 16 is doped to have an opposite conductivity type from the semiconductor layer 14. The doped region 16 has a lower boundary that defines an interface with the underlying semiconductor material of the semiconductor layer 14 across which the dopant type changes. In an embodiment, the doped region 16 may define a body of the field-effect transistor.

The doped region 16 may be formed by introducing a dopant of a given conductivity type by, for example, ion implantation into the semiconductor layer 14. An implantation mask may be formed to define a selected area on a top surface 13 of the semiconductor substrate 11 that is exposed for the implantation of ions. The implantation mask may include a hardmask that is applied and patterned to form an opening exposing the selected area on the top surface 13 and determining, at least in part, the location and horizontal dimensions of the doped region 16. The implantation conditions (e.g., ion species, dose, kinetic energy, substrate temperature) may be selected to tune the electrical and physical characteristics of the doped region 16, to minimize defects, and to maximize the ionization and activation of the implanted dopants. In an embodiment, the ion implantation may be performed at substrate temperature in a range of 200°C to 600°C to minimize defect formation. The implantation mask, which is compatible with the implantation conditions and is stripped following implantation, has a thickness and stopping power sufficient to block the implantation of ions in masked areas. In an embodiment, the doped region 16 may be doped with a concentration of a p-type dopant (e.g., aluminum) to provide p-type electrical conductivity.

Contacts 19 may be formed at the periphery of the doped region 16. The contacts 19 may be formed by ion implantation using an implantation mask, and the contacts 19 may have the same conductivity type (e.g., p-type) as the doped region 16 but at a higher dopant concentration. The contacts 19 may provide body contacts to the body of the field-effect transistor defined by the doped region 16.

A doped region 18 may be formed in the semiconductor layer 14 adjacent to a top surface 13 of the semiconductor substrate 11. The doped region 18 has the same conductivity type as the semiconductor layer 14 but at a higher dopant concentration. The doped region 18 has an upper boundary that may be coplanar or substantially coplanar with the top surface 13 of the semiconductor substrate 11 and a lower boundary that defines an interface with the doped region 16 across which the conductivity type changes. In an embodiment, the doped region 18 may define a source of the field-effect transistor.

The doped region 18 may be formed by introducing a dopant of a given conductivity type by, for example, ion implantation into the semiconductor layer 14. An implantation mask may be formed to define a selected area on a top surface 13 of the semiconductor substrate 11 that is exposed for the implantation of ions. The implantation mask may include a hardmask that is applied and patterned to form an opening exposing the selected area on the top surface 13 of the semiconductor substrate 11 and determining, at least in part, the location and horizontal dimensions of the doped region 18. The implantation conditions (e.g., ion species, dose, kinetic energy, substrate temperature) may be selected to tune the electrical and physical characteristics of the doped region 18. In an embodiment, the ion implantation may be performed at substrate temperature in a range of 200°C to 600°C to minimize defect formation. The implantation mask, which is compatible with the implantation conditions and is stripped following implantation, has a thickness and stopping power sufficient to block the implantation of ions in masked areas. In an embodiment, the doped region 18 may be doped with a concentration of an n-type dopant (e.g., nitrogen and/or phosphorus) to provide n-type electrical conductivity. In an embodiment, the doped region 18 may be doped with a higher concentration of the n-type dopant than the semiconductor layer 14.

A hardmask 20 is applied on the top surface 13 of the semiconductor substrate 11 and, in particular, the hardmask 20 may be disposed on the top surface 13 over the doped regions 16, 18. The hardmask 20 may be comprised of a material that is characterized by a high melting point. In an embodiment, the hardmask 20 may be comprised of a material that is characterized by a melting point greater than or equal to 2000°C. In an embodiment, the hardmask 20 may be comprised of a material that is an electrical insulator and that is characterized by a melting point greater than or equal to 2000°C. In an embodiment, the hardmask 20 may be comprised of a material that is an insulating ceramic having a melting point greater than or equal to 2000°C. In an embodiment, the hardmask 20 may be comprised of a material that is a high-resistivity semiconductor material having a melting point greater than or equal to 2000°C. In an embodiment, the hardmask 20 may be comprised of a material characterized by a coefficient of thermal expansion that is similar to the coefficient of thermal expansion of crystalline silicon carbide.

In embodiments, the hardmask 20 may include one or more layers each comprised of a material that is characterized by a melting point greater than or equal to 2000°C. In an embodiment, the hardmask 20 may include a layer comprised of aluminum nitride. In an embodiment, the hardmask 20 may include a layer comprised of polycrystalline silicon carbide. In an embodiment, the hardmask 20 may include a layer comprised of either aluminum nitride or polycrystalline silicon carbide that is disposed on a layer comprised of aluminum oxide. In an embodiment, the hardmask 20 may include a layer comprised of polycrystalline silicon carbide that is disposed on a layer comprised of aluminum nitride.

With reference to FIG. 2 in which like reference numerals refer to like features in FIG. 1 and at a subsequent fabrication stage, trenches 22 are formed by lithography and etching processes that extend through the hardmask 20 into the semiconductor substrate 11. More specifically, each trench 22 includes an upper portion that extends through the hardmask 20 and a lower portion that extends from the top surface 13 of the semiconductor substrate 11 through both of the doped regions 16, 18 and into the semiconductor layer 14 beneath the doped region 16. Each trench 22, which may have a width dimension W, has a sidewall 24 and a trench bottom 26 that is positioned between the top surface 13 and the interface between the bulk substrate 12 and the semiconductor layer 14. In contrast to conventional process flows, the hardmask 20 is not removed from the top surface 13 after the trenches 22 are formed.

A doped region 28 may be formed in the semiconductor layer 14 beneath the trench bottom 26 of each of the trenches 22. The doped regions 28 are positioned in a vertical direction between the trenches 22 and the bulk substrate 12 operating as the drain of the field-effect transistor. The doped regions 28 have an opposite conductivity type from the semiconductor layer 14 and the doped region 16. The doped regions 28 may participate in defining a p-shield of the field-effect transistor.

The doped regions 28 may be formed by introducing a dopant of a given conductivity type by, for example, ion implantation into the semiconductor layer 14. The trenches 22 in the hardmask 20 may determine, at least in part, the location and horizontal dimensions of the doped regions 28. The hardmask 20 has a thickness and stopping power sufficient to block the implantation of ions in masked areas. The implantation conditions (e.g., ion species, dose, kinetic energy, substrate temperature) may be selected to tune the electrical and physical characteristics of the doped regions 28. In an embodiment, the doped regions 28 may be doped with a concentration of a p-type dopant (e.g., aluminum) to provide p-type electrical conductivity.

A high-temperature anneal may be performed following the implantations to activate the implanted dopants and to alleviate post-implantation crystal damage. The high-temperature anneal may be performed with a removable carbon capping layer applied as a temporary coating on the hardmask 20 and at a high temperature, such as a temperature in a range of 1600°C to 1900°C. The hardmask 20, which can withstand the high anneal temperature, is disposed on the top surface 13 during the anneal and functions to enhance the surface protection during the anneal. The removable carbon capping layer may prevent silicon outgassing from surface areas, such as those surface areas inside the trenches 22, that are not covered and protected by the hardmask 20 during the high-temperature anneal. The carbon capping layer, which may be comprised of burned photoresist or a deposited layer of carbon, is removed following the high-temperature anneal. In a conventional process flow, all hardmasks are removed before the high-temperature anneal.

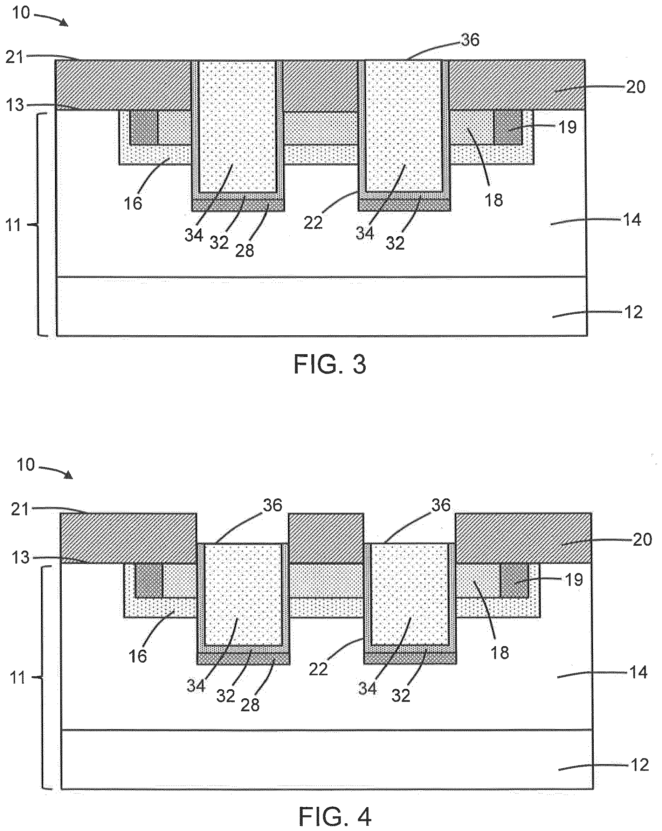

With reference to FIG. 3 in which like reference numerals refer to like features in FIG. 2 and at a subsequent fabrication stage, a gate structure including a gate dielectric layer 32 and a gate conductor layer 34 is formed inside each of the trenches 22. In an embodiment, the gate conductor layers 34 may be comprised of polysilicon that is heavily doped with an n-type dopant, such as phosphorus or arsenic, and the gate dielectric layers 32 may be comprised of a dielectric material, such as silicon dioxide, that is an electrical insulator. The gate dielectric layers 32 and gate conductor layers 34 may be deposited and then etched back using either reactive ion etching or chemical mechanical polishing such that each gate conductor layer 34 has a top surface 36 that is coplanar or substantially coplanar with a top surface 21 of the hardmask 20. Each gate conductor layer 34 extends through the hardmask 20 and the doped regions 16, 18 in the semiconductor substrate 11. The hardmask 20, which is present on the top surface 13, assists with self-alignment during the formation of the gate structures in the trenches 22. The gate dielectric layer 32 and gate conductor layer 34 of each gate structure project in a vertical direction above the top surface 13 due to the existence of the upper portions of the trenches 22 in the hardmask 20.

With reference to FIG. 4 in which like reference numerals refer to like features in FIG. 3 and at a subsequent fabrication stage, the gate dielectric layer 32 and the gate conductor layer 34 may be recessed by an etching process such that the top surface 36 of each gate conductor layer 34 is disposed within the trenches 22 below the top surface 21 of the hardmask 20. In an embodiment, the top surface 36 of each gate conductor layer 34 may be disposed in a vertical direction between the top surface 21 of the hardmask 20 and the top surface 13 of the semiconductor substrate 11. Each gate conductor layer 34 has an upper portion disposed above the top surface 13 of the semiconductor substrate 11 and a lower portion disposed in one of the trenches 22 below the top surface 13 of the semiconductor substrate 11. The upper and lower portions of each gate conductor layer 34 are disposed on opposite sides of the top surface 13 of the semiconductor substrate 11.

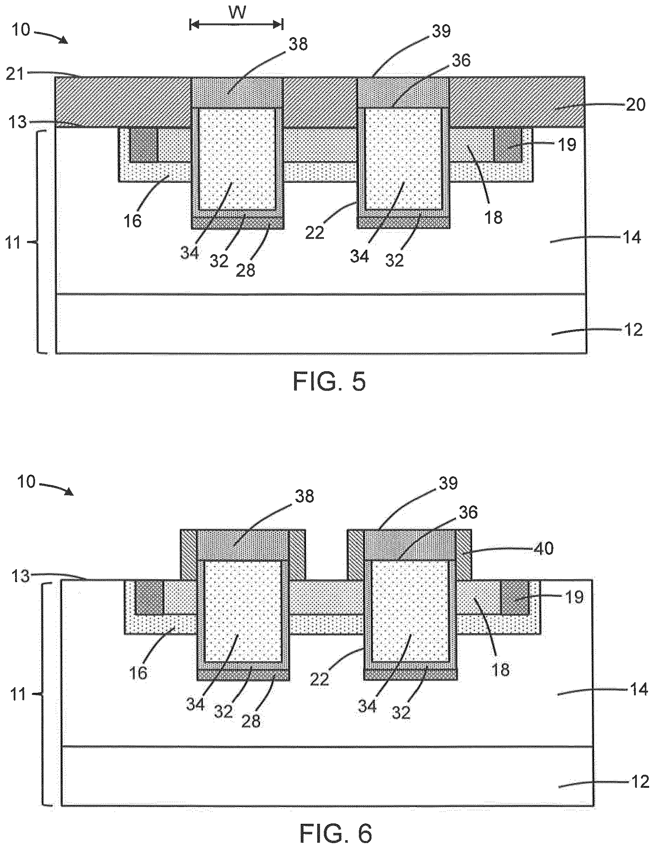

With reference to FIG. 5 in which like reference numerals refer to like features in FIG. 4 and at a subsequent fabrication stage, dielectric layers 38 are formed in the open spaces inside the trenches 22 over the recessed gate conductor layers 34. The dielectric layers 38 may be comprised of a dielectric material, such as silicon dioxide, that is an electrical insulator. In an embodiment, the dielectric layers 38 may be formed by depositing a dielectric material and polishing the dielectric material by chemical mechanical polishing to be coplanar or substantially coplanar with the top surface 21 of the hardmask 20. In an alternative embodiment, the formation of the dielectric layers 38 may include oxidizing the material of the gate conductor layers 34 by an oxidation process and polishing the oxidized material. The oxidation temperature may be selected in order to maximize the oxidation of the material constituting the gate conductor layers 34 and to minimize the oxidation of surrounding materials, such as the material of the hardmask 20.

The dielectric layers 38 may have a top surface 39 that is coplanar or substantially coplanar with the top surface 21 of the hardmask 20. Due to the spatial constraint imposed by the upper portions of the trenches 22 in the hardmask 20, the dielectric layers 38 may have a width dimension that is equal or substantially equal to the width dimension W of the trenches 22. The formation of the dielectric layers 38 inside the upper portions of the trenches 22 may enable an increase in the thickness of the dielectric layers 38.

With reference to FIG. 6 in which like reference numerals refer to like features in FIG. 5 and at a subsequent fabrication stage, the hardmask 20 may be removed from the top surface 13 by an etching process. The removal of the hardmask 20 reveals the top surface 13 of the semiconductor substrate 11 and provides access for contacting the doped regions 16, 18. The hardmask 20 may be removed without disturbing the dielectric layers 38, which are also revealed when the hardmask 20 is removed.

Dielectric spacers 40 may be formed on the sidewalls of the dielectric layers 38. In an embodiment, the dielectric spacers 40 may be comprised of a dielectric material, such as silicon nitride, silicon oxynitride, or silicon dioxide, that is an electrical insulator and that is conformally deposited and then anisotropically etched. In an alternative embodiment, the dielectric spacers 40 may be omitted from the structure 10.

Middle-of-line processing and back-end-of-line processing may follow, which includes formation of silicide, contacts, vias, and wiring for an interconnect structure that is coupled to the structure 10. In an embodiment, the completed structure 10 may be used to form a metal-oxide-semiconductor field-effect transistor.

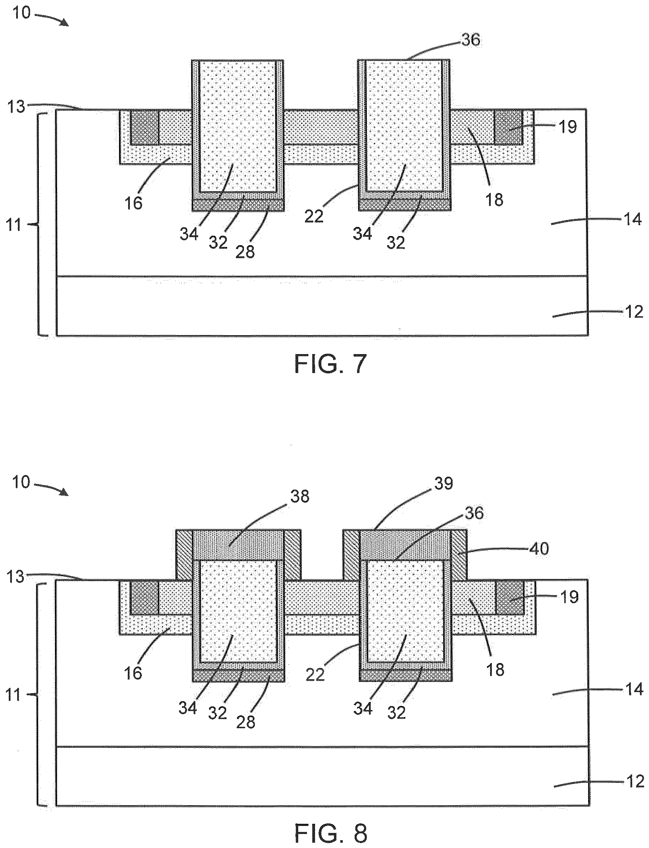

With reference to FIG. 7 and in accordance with alternative embodiments, the hardmask 20 may be removed after the gate conductor layers 34 are formed and without recessing the gate conductor layers 34 before the removal of the hardmask 20. The upper portion of each gate conductor layer 34 is disposed above the top surface 13 of the semiconductor substrate 11 and is no longer surrounded by the hardmask 20.

With reference to FIG. 8 in which like reference numerals refer to like features in FIG. 7 and at a subsequent fabrication stage, the dielectric layers 38 may be formed on the upper portions of the gate conductor layers 34 after removing the hardmask 20. In an embodiment, the dielectric layers 38 may be formed by an oxidation process, which effectively shortens the height of each gate conductor layer 34.

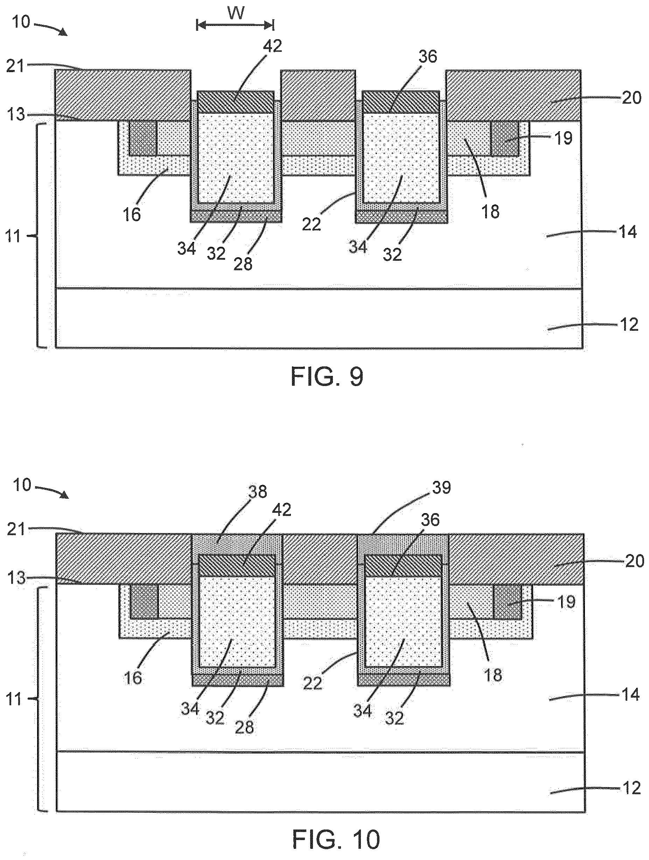

With reference to FIG. 9 and in accordance with alternative embodiments, a silicide layer 42 may be formed by a silicidation process on each gate conductor layer 34. The trenches 22 in the hardmask 20 enable the silicide layers 42 to be formed with self-alignment to the gate conductor layers 34. Due to the spatial constraint imposed by the trenches 22, the silicide layers 42 may have a width dimension that is equal or approximately equal to the width dimension W of the trenches 22. In an embodiment, the silicide layers 42 may be disposed below the top surface 21 of the hardmask 20.

In an embodiment, the silicide layers 42 may be formed by depositing a silicide-forming metal, performing one or more annealing steps to form a silicide phase by reacting the silicide-forming metal with the semiconductor material of the gate conductor layers 34, and selectively removing any unreacted silicide-forming metal. The silicide layers 42 may then be subjected to an additional annealing step at a higher temperature to form a lower-resistance silicide phase. In an embodiment, the silicide-forming metal employed to form the silicide layers 42 may be comprised of nickel.

With reference to FIG. 10 in which like reference numerals refer to like features in FIG. 9 and at a subsequent fabrication stage, the dielectric layers 38 may be formed on the upper portions of the gate conductor layers 34 after forming the silicide layers 42. In an embodiment, the dielectric layers 38 may be deposited and planarized to fill the spaces inside the trenches 22 over the silicide layers 42.

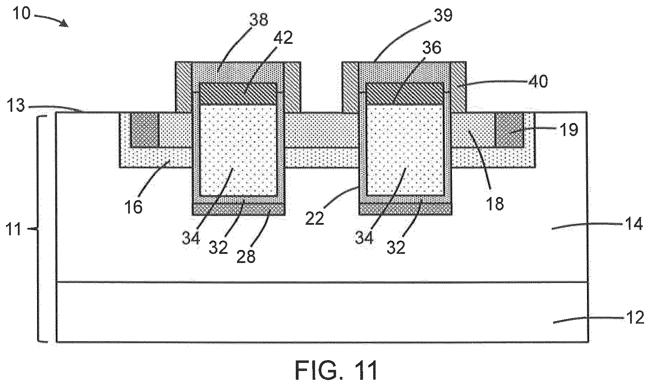

With reference to FIG. 11 in which like reference numerals refer to like features in FIG. 10 and at a subsequent fabrication stage, the hardmask 20 may be removed by an etching process after forming the dielectric layers 38, followed by the optional formation of the dielectric spacers 40. The hardmask 20 may be removed without disturbing the dielectric layers 38.

The methods as described above are used in the fabrication of integrated circuit chips. The resulting integrated circuit chips can be distributed by the fabricator in raw wafer form (e.g., as a single wafer that has multiple unpackaged chips), as a bare die, or in a packaged form. The chip may be integrated with other chips, discrete circuit elements, and/or other signal processing devices as part of either an intermediate product or an end product. The end product can be any product that includes integrated circuit chips, such as computer products having a central processor or smartphones.

References herein to terms modified by language of approximation, such as "about", "approximately", and "substantially", are not to be limited to the precise value specified. The language of approximation may correspond to the precision of an instrument used to measure the value and, unless otherwise dependent on the precision of the instrument, may indicate a range of +/- 10% of the stated value(s).

References herein to terms such as "vertical", "horizontal", etc. are made by way of example, and not by way of limitation, to establish a frame of reference. The term "horizontal" as used herein is defined as a plane parallel to a conventional plane of a semiconductor substrate, regardless of its actual three-dimensional spatial orientation. The terms "vertical" and "normal" refer to a direction in the frame of reference perpendicular to the horizontal, as just defined. The term "lateral" refers to a direction in the frame of reference within the horizontal plane.

A feature "connected" or "coupled" to or with another feature may be directly connected or coupled to or with the other feature or, instead, one or more intervening features may be present. A feature may be "directly connected" or "directly coupled" to or with another feature if intervening features are absent. A feature may be "indirectly connected" or "indirectly coupled" to or with another feature if at least one intervening feature is present. A feature "on" or "contacting" another feature may be directly on or in direct contact with the other feature or, instead, one or more intervening features may be present. A feature may be "directly on" or in "direct contact" with another feature if intervening features are absent. A feature may be "indirectly on" or in "indirect contact" with another feature if at least one intervening feature is present. Different features "overlap" if a feature extends over, and covers a part of, another feature.

The descriptions of the various embodiments of the present invention have been presented for purposes of illustration but are not intended to be exhaustive or limited to the embodiments disclosed. Many modifications and variations will be apparent to those of ordinary skill in the art without departing from the scope and spirit of the described embodiments. The terminology used herein was chosen to best explain the principles of the embodiments, the practical application or technical improvement over technologies found in the marketplace, or to enable others of ordinary skill in the art to understand the embodiments disclosed herein.

## Claims

1. A structure for a field-effect transistor, the structure comprising:
a semiconductor substrate including a top surface, a doped region adjacent to the top surface, and a trench that extends through the doped region, the semiconductor substrate comprising a wide bandgap semiconductor material; and
a gate structure including a gate conductor layer, the gate conductor layer having a first portion disposed above the top surface of the semiconductor substrate and a second portion disposed inside the trench below the top surface of the semiconductor substrate.

2. The structure of claim 1 wherein the gate structure further includes a silicide layer on the first portion of the gate conductor layer.

3. The structure of claim 2 wherein the silicide layer and the trench have substantially equal width dimensions.

4. The structure of one of claims 1 to 3 further comprising:
a dielectric layer on the first portion of the gate conductor layer,
wherein the dielectric layer and the trench have substantially equal width dimensions.

5. The structure of claim 4 further comprising:
a dielectric spacer on the dielectric layer.

6. The structure of one of claims 1 to 5 wherein the gate conductor layer extends through the doped region, and/or wherein the wide bandgap semiconductor material comprises silicon carbide.

7. A method of forming a structure for a field-effect transistor, the method comprising:
forming a doped region in a semiconductor substrate adjacent to a top surface of the semiconductor substrate, wherein the semiconductor substrate comprises a wide bandgap semiconductor material;
forming a trench in the semiconductor substrate, wherein the trench extends through the doped region; and
forming a gate structure including a gate conductor layer, wherein the gate conductor layer has a first portion disposed above the top surface of the semiconductor substrate and a second portion disposed inside the trench below the top surface of the semiconductor substrate.

8. The method of claim 7 wherein forming the trench in the semiconductor substrate comprises:
forming a hardmask on the top surface of the semiconductor substrate,
wherein the trench extends through the hardmask into the semiconductor substrate.

9. The method of claim 8 further comprising:
forming a silicide layer on the first portion of the gate conductor layer; and
removing the hardmask after forming the silicide layer.

10. The method of claim 8 further comprising:
recessing the gate conductor layer relative to a top surface of the hardmask, wherein the gate conductor layer has a top surface disposed between the top surface of the hardmask and the top surface of the semiconductor substrate.

11. The method of claim 10 further comprising:
forming a silicide layer on the gate conductor layer;
forming a dielectric layer inside a portion of the trench over the silicide layer and the gate conductor layer; and
removing the hardmask after forming the silicide layer and the dielectric layer.

12. The method of claim 10 further comprising:
forming a dielectric layer inside a portion of the trench over the gate conductor layer.

13. The method of one of claims 8 to 12 wherein the hardmask comprises a material having a melting point that is greater than or equal to 2000°C, or wherein the hardmask comprises aluminum nitride, or wherein the hardmask comprises polycrystalline silicon carbide.

14. The method of one of claims 8 to 12 wherein the hardmask includes a first layer and a second layer that is disposed on the first layer, the first layer comprises aluminum oxide, and the second layer comprises aluminum nitride or polycrystalline silicon carbide, or the first layer comprises aluminum nitride, and the second layer comprises polycrystalline silicon carbide.

15. The method of claims 8, 13 and 14 further comprising:
removing the hardmask after forming the gate structure; and
forming a dielectric layer by an oxidation process on the gate conductor layer after removing the hardmask.
